# EUROPEAN PATENT APPLICATION

(11) **EP 4 517 840 A1**
(43) Date of publication of application: **05.03.2025**
(21) Application number: 23794681.9
(22) Date of filing: 08.02.2023
(51) Int. Cl.: H01L 31/103, H01L 31/0232, H01L 31/0352

(54) **PHOTOELECTRIC DETECTOR AND OPTICAL CHIP**

(30) Priority: 27.04.2022 CN 202210451423
(71) Applicant: Innolight Technology (Suzhou) Ltd., Suzhou, Jiangsu 215000 (CN)
(72) Inventor: WU, Hao, Suzhou, Jiangsu 215000 (CN); ZHENG, Xuezhe, Suzhou, Jiangsu 215000 (CN)
(74) Representative: Becker, Eberhard
(86) International application number: PCT/CN2023/074946
(87) International publication number: WO 2023/207245

(57) **Abstract**

The present application relates to a photoelectric detector and an optical chip. The photoelectric detector comprises: a light guide part, located in the first area and used for conducting incident light; an absorption part, located in a second area connected to the first area, connected to the light guide part and used for absorbing incident light and generating photon-generated carriers; a semiconductor conductive part, comprising an N-type conductive part and a P-type conductive part, the N-type conductive part and the P-type conductive part being located on the two sides of the absorption part, respectively; and an electrode part, comprising a cathode and an anode, the cathode being connected to the N-type conductive part, and the anode being connected to the P-type conductive part. A conductive area between the absorption part and the electrode part extends from the second area to the first area. According to embodiments of the present application, the performance of the photoelectric detector can be effectively improved.

## Description

This application claims the priority benefit of China application filed on April 27, 2022, no. 202210451423.X, with the title of invention being "PHOTOELECTRIC DETECTOR AND OPTICAL CHIP". The entirety of the above-mentioned patent applications is hereby incorporated by reference herein and made a part of this specification.

### Technical Field

The present application relates to the field of optoelectronic technology, and in particular to a photoelectric detector and an optical chip.

### Related Art

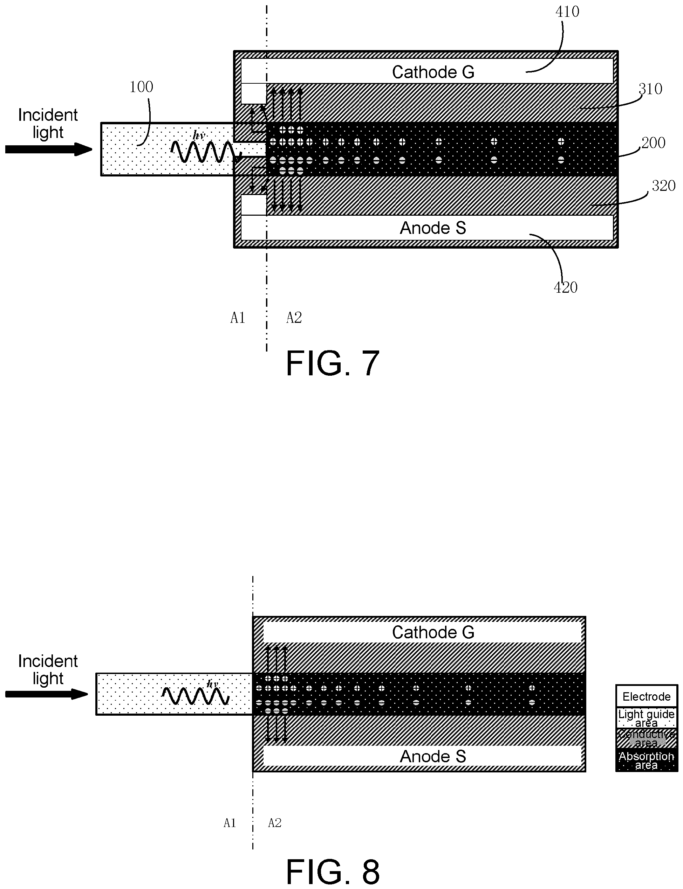

The photoelectric structure of waveguide photoelectric detection is usually as shown in FIG. 8. Through the light guide part at the front end of the detector, the incident light is conducted into the absorption part, absorbed by the absorption material at the absorption part, and free carriers in the material are excited. The excited free carriers move toward the cathode and anode respectively under the action of the built-in electric field of the photoelectric detector and the external electric field formed by an applied bias voltage, thereby forming a photocurrent.

In order to ensure the responsiveness, the conventional photoelectric detector is usually designed with a consistent cross-section along the light transmission direction. As a result, after the light enters the photoelectric detector, the front end absorbs more light energy and the free carriers are densely distributed, and the free carriers are less distributed as the transmission light power decays at the rear end. Therefore, the current density in the conductive area at the front end of the detector is larger, and the current density in the conductive area at the rear end is smaller. When the incident light is stronger than a certain threshold, the free carrier density at the front end of the detector is higher, and the photocurrent density is larger, the electric field generated by the external bias in the absorption area is offset, resulting in a decrease in intensity, thereby affecting the drift velocity of the free carriers in the electric field, ultimately leading to a reduction in the operating bandwidth and responsiveness performance of the detector.

### SUMMARY OF INVENTION

### Technical Problem

Based on the above, the embodiments of the present application provide a photoelectric detector and an optical chip that can effectively improve the drift velocity of free carriers.

### Technical Solution to Problem

A photoelectric detector includes as follows:

A light guide part is located in a first area and used for conducting an incident light.

An absorption part is located in a second area connected to the first area, connected to the light guide part, and used for absorbing the incident light and generating photon-generated carriers.

A semiconductor conductive part includes an N-type conductive part and a P-type conductive part, in which the N-type conductive part and the P-type conductive part are located on two sides of the absorption part respectively.

An electrode part includes a cathode and an anode, in which the cathode is connected to the N-type conductive part, and the anode is connected to the P-type conductive part.

A conductive area between the absorption part and the electrode part extends from the second area to the first area.

In an embodiment, the N-type conductive part and/or the P-type conductive part extends from the second area to the first area.

In an embodiment, the cathode and/or the anode extends from the second area to the first area.

In an embodiment, the N-type conductive part and/or the P-type conductive part overlaps with the light guide part.

In an embodiment,
The cathode includes a front end portion, the front end portion is located at an end of the cathode close to the first area, and a distance between the front end portion and the absorption part is smaller than a distance between other parts of the cathode and the absorption part.
   And/or,
The anode includes a front end portion, the front end portion is located at an end of the anode close to the first area, and a distance between the front end portion and the absorption part is smaller than a distance between other parts of the anode and the absorption part.

In an embodiment, the photoelectric detector has a horizontal structure.

In an embodiment, the photoelectric detector has a vertical structure.

In an embodiment, the photoelectric detector includes a PIN type detector or a PN type detector.

In an embodiment, a material of the absorption part and/or the N-type conductive part and/or the P-type conductive part includes but is not limited to any one of SiGe, InP, Si, and GaAs.

An optical chip includes the photoelectric detector described in any one of the above-mentioned embodiments.

### Beneficial Effects

In the photoelectric detector and the optical chip, the conductive area between the absorption part and the electrode part extends from the second area to the first area. At this time, the flow path of the photon-generated carriers formed at the front end of the absorption part is effectively increased during the movement process thereof toward the electrode part. At this time, the photon-generated carriers at the front end of the absorption part are accelerated to move to the electrode part. At the same time, the photon-generated carriers at the front end of the absorption part are moved and dispersed in time, thereby reducing the carrier density at the front end, and thereby effectively improving the problem of reduced electric field strength inside the detector caused by carrier aggregation and high-density current. At this time, compared with conventional technology, the drift velocity of free carriers at the front end of the detector in the electric field can be effectively improved, thereby improving the performance of the detector. After simulation and experimental validation, the maximum light saturation threshold of the detector can be increased by 2dB to 3dB.

### BRIEF DESCRIPTION OF DRAWINGS

In order to more clearly illustrate the technical solutions in the embodiments of the present application or the conventional technology, the drawings required for use in the description of the embodiments or the conventional technology will be briefly introduced below. Certainly, the drawings described below are only some embodiments of the present application, for ordinary technicians in this field, other drawings may be obtained based on these drawings without any creative work.
FIG. 1 and FIG. 2 are schematic structural top views of a photoelectric detector provided in different embodiments.
FIG. 3 and FIG. 4 are schematic structural cross-sectional views of the photoelectric detector provided in different embodiments.
FIG. 5 to FIG. 7 are schematic structural top views of the photoelectric detector provided in some different embodiments.
FIG. 8 is a schematic structural top view of the photoelectric detector in conventional technology.

Reference Signs List: 100 - light guide part, 200 - absorption part, 300 - semiconductor conductive part, 310 - N-type conductive part, 320 - P-type conductive part, 400 - electrode part, 410 - cathode, 420 - anode, 401 - front end portion, 500 - metal conductive structure.

### DESCRIPTION OF EMBODIMENTS

To facilitate understanding of the present application, a more comprehensive description of the present application will be given below with reference to the relevant drawings. Embodiments of the present application are shown in the accompanying drawings. However, the present application may be implemented in many different forms and is not limited to the embodiments described herein. On the contrary, the purpose of providing these embodiments is to make the disclosure of this application more thorough and complete.

Unless defined otherwise, all technical and scientific terms used herein have the same meaning as commonly understood by persons of ordinary skill in the art to which this application belongs. The terms used herein in the description of the present application are only for the purpose of describing specific embodiments and the embodiments are not intended to limit the present application.

It should be understood that when an element or layer is referred to as being "on," "adjacent to," "connected to," or "coupled to" another element or layer, it may be directly on, adjacent to, connected or coupled to the other element or layer, or intervening elements or layers may be present. In contrast, when an element is referred to as being "directly on," "directly adjacent to," "directly connected to," or "directly coupled to" another element or layer, there are no intervening elements or layers present.

It should be understood that although the terms, for example, first, second, third, may be used to describe various elements, components, regions, layers, doping types, and/or sections, the elements, components, regions, layers, doping types, and/or sections should not be limited by the terms. The terms are only used to distinguish one element, component, region, layer, doping type, or section from another element, component, region, layer, doping type, or section. Therefore, without departing from the teachings of the present application, the first element, component, region, layer, doping type, or section discussed below may be represented as a second element, component, region, layer, or section; for example, the first doping type may be referred to as the second doping type, and similarly, the second doping type may be referred to as the first doping type; the first doping type and the second doping type are different doping types. For example, the first doping type may be P-type and the second doping type may be N-type, or the first doping type may be N-type and the second doping type may be P-type.

Spatially relative terms such as "below," "beneath," "underneath," "under," "above," "on" may be used herein to describe the relationship of one element or feature to other elements or features shown in the drawings. It will be understood that the spatially relative terms are intended to encompass different orientations of the device in use and operation in addition to the orientation depicted in the drawings. For example, if the device in the drawing is turned over, elements or features described as "below" or "beneath" or "under" other elements would then be oriented "above" the other elements or features. Thus, the exemplary terms "below" and "beneath" may encompass both orientations of above and below. Furthermore, the device may be included in alternative orientations (for example, rotated 90 degrees or at other orientations), and the spatial descriptors used herein are interpreted accordingly.

As used herein, the singular forms "a", "an", and "the" may include the plural forms as well, unless the context clearly indicates otherwise. It should also be understood that the terms "include/comprise" or "have" and the like specify the presence of stated features, integers, steps, operations, components, parts, or combinations thereof. However, the possibility of the existence or addition of one or more other features, integers, steps, operations, components, parts, or combinations thereof is not excluded. Meanwhile, in this specification, the term "and/or" includes any and all combinations of the relevant listed items.

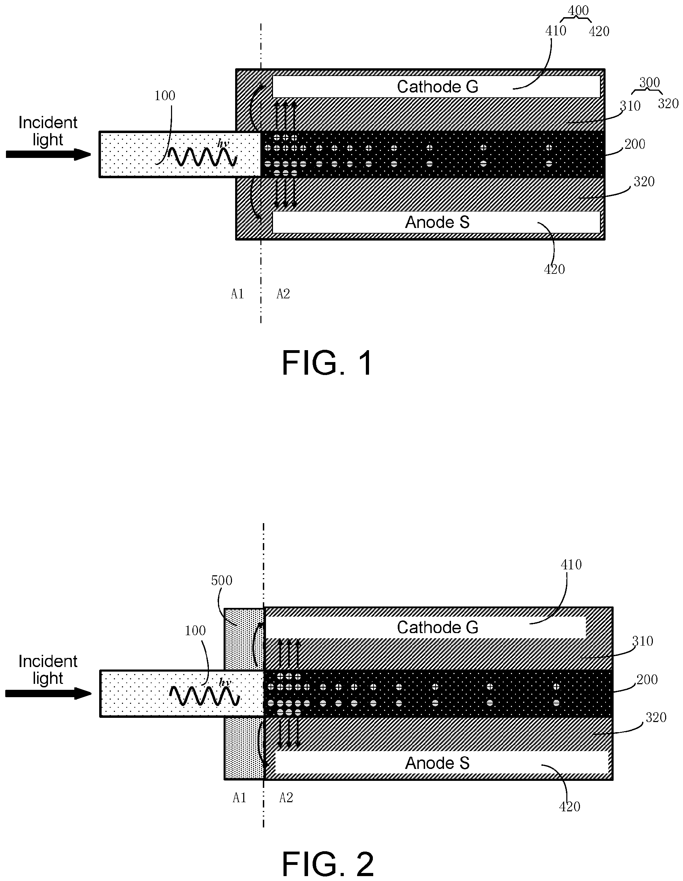

In an embodiment, referring to FIG. 1 or FIG. 2, a photoelectric detector is provided, which includes: a light guide part 100, an absorption part 200, a semiconductor conductive part 300, and an electrode part 400.

Meanwhile, the photoelectric detector has two areas, a first area A1 and a second area A2, which are connected to each other.

The light guide part 100 is disposed in the first area A1 and is used for guiding an incident light to the absorption part 200. Specifically, as an example, the light guide part 100 may be a silicon-based optical waveguide.

The absorption part 200 is located in the second area A2 and connected to the light guide part 100, and is used for absorbing the incident light and generating photon-generated carriers. Specifically, after the incident light is conducted into the absorption part 200 through the light guide part 100, and absorbed by the material of the absorption part 200, free carriers in the material are excited. The free carriers include electrons and holes. Under the action of the built-in electric field of the detector and the external electric field formed by an applied bias voltage, the electrons and holes move toward the anode and cathode respectively, thereby forming a photocurrent.

The semiconductor conductive part 300 includes an N-type conductive part 310 and a P-type conductive part 320. The N-type conductive part 310 and the P-type conductive part 320 are located on two sides of the absorption part 200 respectively.

Specifically, the photoelectric detector may include, for example, a PIN type detector or a PN type detector.

When the photoelectric detector is the PIN type detector, space charge areas are formed near interfaces of an intrinsic layer and the P-type semiconductor and the N-type semiconductor on two sides thereof. The space charge area formed with the P-type semiconductor has a negative charge, and the space charge area formed with the N-type semiconductor has a positive charge. At this time, the intrinsic layer and the space charge areas on the two sides thereof form the absorption part 200.

Meanwhile, the P-type semiconductor and the N-type semiconductor on two sides of the absorption part 200 form a P-type conductive part 320 and an N-type conductive part 310 respectively.

When the photoelectric detector is the PN type detector, a space charge area is formed at the interface between the P type semiconductor and the N type semiconductor, and the space charge area forms the absorption part 200.

Meanwhile, the P-type semiconductor and the N-type semiconductor on the two sides of the absorption part 200 form the P-type conductive part 320 and the N-type conductive part 310 respectively.

As an example, the material of the P-type semiconductor and/or the N-type semiconductor here may include any one of SiGe, InP, Si, and GaAs. At this time, the material of the absorption part and/or the N-type conductive part and/or the P-type conductive part includes any one of SiGe, InP, Si, and GaAs.

Of course, the material of the P-type semiconductor and the N-type semiconductor is not limited thereto, and the material may also include other semiconductor materials.

Meanwhile, the materials of the P-type semiconductor and the N-type semiconductor may be the same or different, and the disclosure is not limited thereto.

The electrode part 400 includes a cathode 410 and an anode 420. The cathode 410 is connected to the N-type conductive part 310, and the anode 420 is connected to the P-type conductive part 320.

Meanwhile, in this embodiment, a conductive area between the absorption part 200 and the electrode part 400 extends from the second area A2 to the first area A1. Specifically, the conductive area between the absorption part 200 and the cathode 410 may extend from the second area A2 to the first area A1, and the conductive area between the absorption part 200 and the anode 420 may extend from the second area A2 to the first area A1; alternatively, only the conductive area between the absorption part 200 and the cathode 410 may extend from the second area A2 to the first area A1; alternatively, only the conductive area between the absorption part 200 and the anode 420 may be extended from the second area A2 to the first area A1.

At this time, the flow path of the photon-generated carriers (electrons and/or holes) formed at the front end of the absorption part 200 is effectively increased during the movement process thereof toward the electrode part 400. At this time, the photon-generated carriers (the electrons and/or holes) at the front end of the absorption part 200 are accelerated to move to the electrode part 400. At the same time, the photon-generated carriers (the electrons and/or holes) at the front end of the absorption part 200 are moved and dispersed in time, thereby reducing the carrier density at the front end, and thereby effectively improving the problem of reduced electric field strength inside the detector caused by high-density current. At this time, compared with conventional technology, the drift velocity of free carriers at the front end of the detector in the electric field can be effectively improved, thereby improving the performance of the detector.

In an embodiment, referring to FIG. 1, the photoelectric detector may have a horizontal structure.

At this time, as an example, the photoelectric detector may be formed by horizontally arranged P-type semiconductor, the intrinsic semiconductor and N-type semiconductor or horizontally arranged to form the PIN structure, thereby forming the P-type conductive part 320, the absorption part 200, and the N-type conductive part 310. Specifically, P-type doping and N-type doping may be performed on two sides of the intrinsic semiconductor respectively, thereby a P-type semiconductor and an N-type semiconductor are formed on the two sides of the intrinsic semiconductor respectively. Of course, the formation method of the P-type semiconductor and the N-type semiconductor is not limited thereto.

At this time, the cathode 410 may be located at a side of the N-type conductive part 310 away from the absorption part 200, and the anode 420 may be located at a side of the P-type conductive part 320 away from the absorption part 200. At this time, the cathode 410 and the anode 420 are both disposed opposite to the absorption part 200, so that corresponding carriers may move to the cathode 410 and the anode 420.

Based on the above, the conductive area between the absorption part 200 and the electrode part 400 is extended from the second area A2 to the first area A1, which can further accelerate the movement speed of the corresponding carriers to the cathode 410 and/or the anode 420; at the same time, compared with conventional technology, the drift velocity of free carriers at the front end of the detector in the electric field can be effectively improved, thereby improving the performance of the detector.

Of course, in other embodiments, the photoelectric detector is not limited to having a horizontal structure.

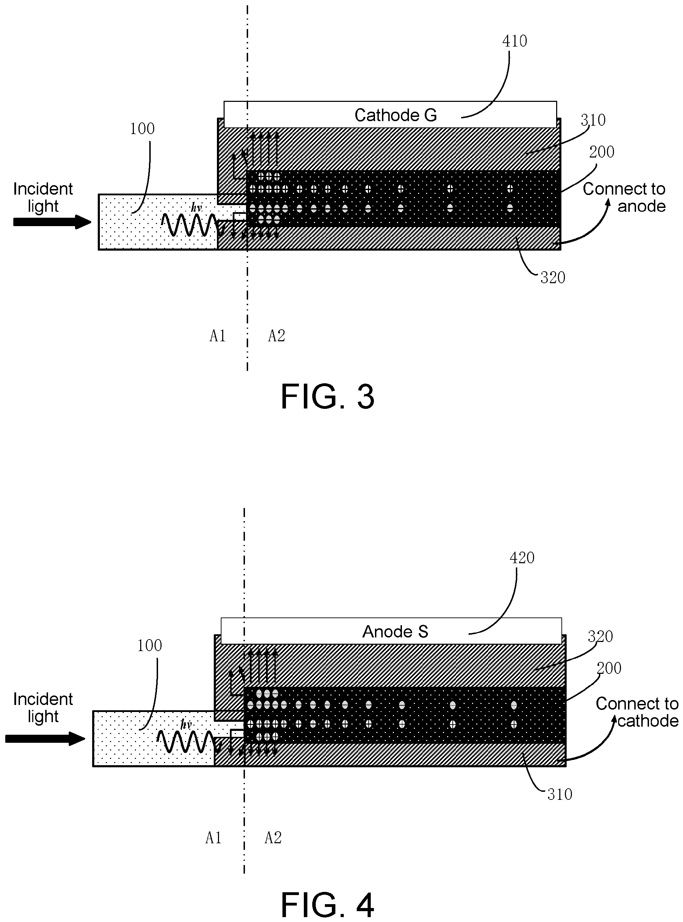

In an embodiment, referring to FIG. 3 or FIG. 4, the photoelectric detector may have a vertical structure.

At this time, as an example, a low-doped intrinsic layer may be formed by epitaxial growth on an N-type semiconductor substrate. Then, epitaxial growth is performed on the intrinsic layer to form a P-type semiconductor layer (or ion implantation is performed on the intrinsic layer to form the P-type semiconductor layer), thereby forming a PIN structure, and thereby forming the P-type conductive part 320, the absorption part 200, and the N-type conductive part 310.

Afterward, referring to FIG. 4, the anode 420 may be formed on the P-type conductive part 320. At the same time, the cathode 410 (not shown in the drawing) is formed on an area of the N-type semiconductor substrate where no intrinsic layer and no P-type semiconductor layer are disposed.

Alternatively, as an example, a low-doped intrinsic layer may be formed by epitaxial growth on a P-type semiconductor substrate. Then, epitaxial growth is performed on the intrinsic layer to form an N-type semiconductor layer (or ion implantation is performed on the intrinsic layer to form the N-type semiconductor layer), thereby forming a PIN structure, and thereby forming the P-type conductive part 320, the absorption part 200, and the N-type conductive part 310.

Afterward, referring to FIG. 3, the cathode 410 may be formed on the N-type conductive part 310. At the same time, the anode 420 (not shown in the drawing) is formed on an area of the P-type semiconductor substrate where no intrinsic layer and no N-type semiconductor layer are disposed.

In the photoelectric detector with the vertical structure of this embodiment, the conductive area between the absorption part 200 and the electrode part 400 extends from the second area A2 to the first area A1, which can also accelerate the movement speed of the corresponding carriers to the cathode 410 and/or the anode 420; at the same time, compared with conventional technology, the drift velocity of free carriers at the front end of the detector in the electric field can be effectively improved, thereby improving the performance of the detector.

In an embodiment, referring to FIG. 1, the N-type conductive part 310 and/or the P-type conductive part 320 extends from the second area A2 to the first area A1.

Specifically, both the N-type conductive part 310 and the P-type conductive part 320 may extend from the second area A2 to the first area A1, alternatively, only the N-type conductive part 310 may extend from the second area A2 to the first area A1, alternatively, only the P-type conductive part 320 may extend from the second area A2 to the first area A1.

The N-type conductive part 310 extends from the second area A2 to the first area A1, so that the conductive area between the cathode 410 and the absorption part 200 is effectively extended from the second area to the first area through the growth of the N-type conductive part 310.

The P-type conductive part 320 extends from the second area A2 to the first area A1, so that the conductive area between the anode 420 and the absorption part 200 is effectively extended from the second area A2 to the first area A1 through the growth of the P-type conductive part 320.

Of course, in other embodiments, the conductive area between the cathode 410 and/or the anode 420 and the absorption part 200 may be extended from the second area A2 to the first area A1 by other methods.

For example, referring to FIG. 2, a metal conductive structure 500 connecting the N-type conductive part 310 and the cathode 410 may be added in the first area A1; and/or, the metal conductive structure 500 connecting the P-type conductive part 320 and the anode 420 is added in the first area A1.

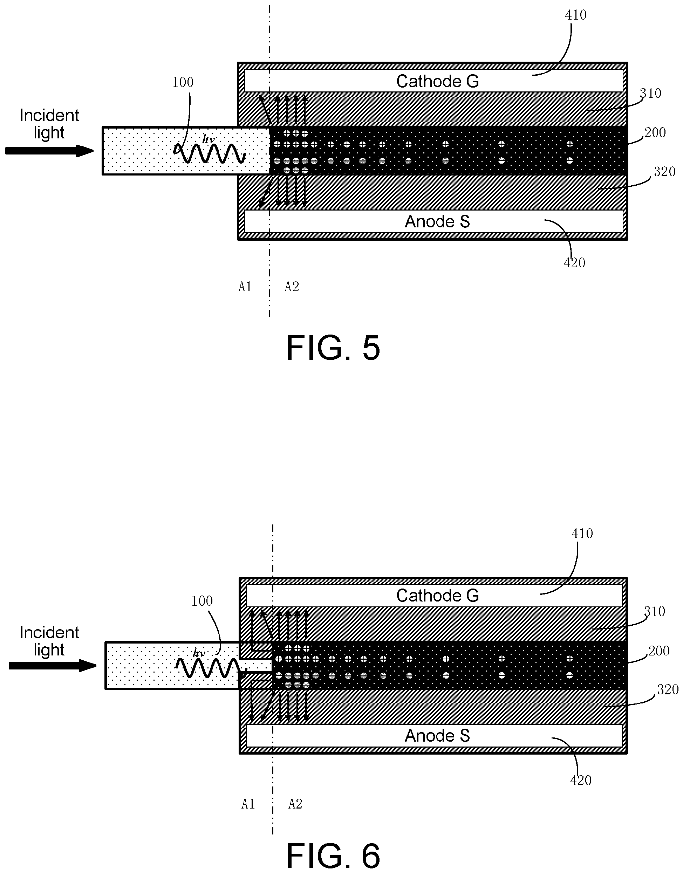

In an embodiment, referring to FIG. 5, the cathode 410 and/or the anode 420 extends from the second area A2 to the first area A1.

Specifically, both the cathode 410 and the anode 420 may extend from the second area A2 to the first area A1, alternatively, only the cathode 410 may extend from the second area A2 to the first area A1, alternatively, only the anode 420 may extend from the second area A2 to the first area A1.

At this time, a targeted area of the conductive area between the cathode 410, the absorption part 200, and the electrode part 400 may be increased, thereby further accelerating the movement of the corresponding carriers to the cathode 410 and the anode 420.

In an embodiment, referring to FIG. 6, the N-type conductive part 310 and/or the P-type conductive part 320 overlaps with the light guide part 100.

Specifically, both the N-type conductive part 310 and the P-type conductive part 320 may overlap with the light guide part 100, or only the N-type conductive part 310 may overlap with the light guide part 100, or only the P-type conductive part 320 may overlap with the light guide part 100.

At this time, the light guide part 100 is used for both guiding light and conducting electricity, so that the absorption part 200 may form a conductive path on the side, thereby the corresponding carriers (the electrons and/or holes) formed at the front end of the absorption part 200 can move to the electrode part 400 more quickly.

In an embodiment, referring to FIG. 7, the cathode 410 includes a front end portion 401. The front end portion 401 of the cathode 410 is located at an end of the cathode 410 close to the first area A1, and a distance between the front end portion 401 of the cathode 410 and the absorption part 200 is smaller than a distance between other parts of the cathode 410 and the absorption part 200, and/or, the anode 420 includes a front end portion 401, the front end portion 401 of the anode 420 is located at an end of the anode 420 close to the first area A1, and a distance between the front end portion 401 of the anode 420 and the absorption part 200 is smaller than a distance between other parts of the anode 420 and the absorption part 200.

At this time, since the distance between the electrode part 400 and the front end of the absorption part 200 is effectively shortened, the corresponding carriers (the electrons and/or holes) formed at the front end of the absorption part 200 can move to the electrode part 400 more quickly.

In an embodiment, an optical chip is further provided, which includes the photoelectric detector as described in any one of the above-mentioned embodiments.

As an example, any two, any three, or any four of the light guide part 100, the absorption part 200, the semiconductor conductive part 300, and the electrode part 400 on the optical chip may be formed by corresponding processing based on the same material.

Of course, different parts may also be processed based on different materials, and the disclosure is not limited thereto.

In the description of this specification, the reference terms, for example, "an embodiment", or "other embodiments" mean that the specific features, structures, materials, or characteristics described together with the embodiment or example are included in at least an embodiment or example of the present application. In this specification, the illustrative descriptions of the above terms do not necessarily refer to the same embodiment or example.

The technical features of the above-mentioned embodiments may be combined arbitrarily. In order to make the description concise, not all possible combinations of the technical features of the above-mentioned embodiments are described. However, as long as there is no contradiction in the combination of the technical features, the features should be considered to be within the scope of this specification.

The above-described embodiments merely express several implementation methods of the present application, and the description thereof is relatively specific and detailed, but the embodiments should not be construed as limiting the scope of the patent application. It should be pointed out that, for ordinary technicians in this field, several modifications and improvements may be made without departing from the concept of the present application, which all fall within the scope of protection of the present application. Therefore, the scope of protection of this patent application should be based on the appended claims.

## Claims

1. A photoelectric detector, **characterized by**, comprising:
a light guide part located in a first area and used for conducting an incident light;
an absorption part located in a second area connected to the first area, connected to the light guide part, and used for absorbing the incident light and generating photon-generated carriers;
a semiconductor conductive part comprising an N-type conductive part and a P-type conductive part, wherein the N-type conductive part and the P-type conductive part are located on two sides of the absorption part respectively;
an electrode part comprising a cathode and an anode, wherein the cathode is connected to the N-type conductive part, and the anode is connected to the P-type conductive part; and
a conductive area between the absorption part and the electrode part extending from the second area to the first area.

2. The photoelectric detector according to claim 1, **characterized in that**, the N-type conductive part and/or the P-type conductive part extends from the second area to the first area.

3. The photoelectric detector according to claim 1, **characterized in that**, the cathode and/or the anode extends from the second area to the first area.

4. The photoelectric detector according to claim 1, **characterized in that**, the N-type conductive part and/or the P-type conductive part overlaps with the light guide part.

5. The photoelectric detector according to claim 1, **characterized in that**,
the cathode comprises a front end portion, the front end portion is located at an end of the cathode close to the first area, and a distance between the front end portion and the absorption part is smaller than a distance between other parts of the cathode and the absorption part,
and/or,
the anode comprises a front end portion, the front end portion is located at an end of the anode close to the first area, and a distance between the front end portion and the absorption part is smaller than a distance between other parts of the anode and the absorption part.

6. The photoelectric detector according to claim 1, **characterized in that**, the photoelectric detector has a horizontal structure.

7. The photoelectric detector according to claim 1, **characterized in that**, the photoelectric detector has a vertical structure.

8. The photoelectric detector according to claim 1, **characterized in that**, the photoelectric detector comprises a PIN type detector or a PN type detector.

9. The photoelectric detector according to claim 1, **characterized in that** a material of the absorption part and/or the N-type conductive part and/or the P-type conductive part comprises any one of SiGe, InP, Si, and GaAs.

10. An optical chip, **characterized by**, comprising the photoelectric detector according to claim 1.
